Europäisches Patentamt

European Patent Office

Office européen des brevets

(19)

(11) Numéro de publication: **0 084 003**
**A2**

(12) **DEMANDE DE BREVET EUROPEEN**

(21) Numéro de dépôt: **83400018.4**

(22) Date de dépôt: **04.01.83**

(51) Int. Cl.³: **H 01 S 3/13**
**H 01 S 3/02, G 02 B 5/14**

(30) Priorité: **08.01.82 FR 8200235**

(43) Date de publication de la demande:
**20.07.83 Bulletin 83/29**

(84) Etats contractants désignés:
**DE GB NL SE**

(71) Demandeur: **THOMSON-CSF**
**173, Boulevard Haussmann**
**F-75379 Paris Cedex 08(FR)**

(72) Inventeur: **Duda, Eugène**
**THOMSON-CSF SCPI 173, bld Haussmann**
**F-75379 Paris Cedex 08(FR)**

(72) Inventeur: **De Decker, Roger**
**THOMSON-CSF SCPI 173, bld Haussmann**
**F-75379 Paris Cedex 08(FR)**

(72) Inventeur: **Tondu, Claude**
**THOMSON-CSF SCPI 173, bld Haussmann**
**F-75379 Paris Cedex 08(FR)**

(74) Mandataire: **Wang, Pierre et al,**
**THOMSON-CSF SCPI 173, Bld Haussmann**
**F-75379 Paris Cedex 08(FR)**

(54) Dispositif de stabilisation de la puissance optique d'un laser semi-conducteur.

(57) Dispositif de stabilisation de la puissance optique d'un laser semiconducteur.

La puissance optique utile d'un laser (C) semi-conducteur sort par sa face avant $(f_1)$. La puissance de contrôle sort de la face arrière $(f_2)$, et entre dans un guide optique (G), formé par l'assemblage de deux pièces (22, 23). La lumière guidée tombe sur le photodétecteur de contrôle (5). Le courant détecté commande la puissance électrique de commande (4) du laser (C).

Application à la stabilisation d'un laser de lecture d'un disque optique.

./...

FIG.3

# DISPOSITIF DE STABILISATION DE LA PUISSANCE OPTIQUE D'UN LASER SEMI-CONDUCTEUR

La présente invention concerne les diodes laser émettant une puissance optique stabilisée. Une partie de la puissance émise étant reçue par un photodétecteur, dont le signal est utilisé pour l'asservissement de la puissance laser.

Des lasers semi-conducteurs stabilisés sont utilisés notamment pour l'écriture et la lecture de disques optiques. Pour cette application il faut stabiliser la puissance au moins à 1%.

Il est connu de prélever la puissance de contrôle sur la face arrière du cristal laser en plaçant le photodétecteur sur le faisceau de contrôle.

Le désavantage de ce dispositif est dû au fait qu'une faible partie seulement de la puissance prélevée est reçue par le photodétecteur, ce qui rend difficile le contrôle et l'asservissement de la puissance émise. De plus pour ce montage, de la lumière parasite peut tomber sur le photodétectteur et perturber le contrôle.

Brièvement, c'est un dispositif de stabilisation de la puissance optique de sortie d'un laser semi-conducteur émettant par sa face avant une puissance utile et par sa face arrière une puissance de contrôle reçue par un photodétecteur, dont le signal électrique est appliqué à un circuit d'asservissement de l'alimentation de la diode laser caractérisé par le fait que la puissance de contrôle sortant par la face arrière du cristal laser entre dans un guide optique et que la puissance sortant de ce guide est reçue par le photodétecteur.

D'autres caractéristiques et avantages ressortiront de la description, qui va suivre illustrée par les figures qui représentent :

figure 1 - le montage de stabilisation suivant l'art antérieur ;

figure 2 - un montage de stabilisation avec fibre optique.

figure 3 - un montage de stabilisation comprenant un guide optique, suivant l'invention ;

figure 4 et 5 - des formes de guide ;

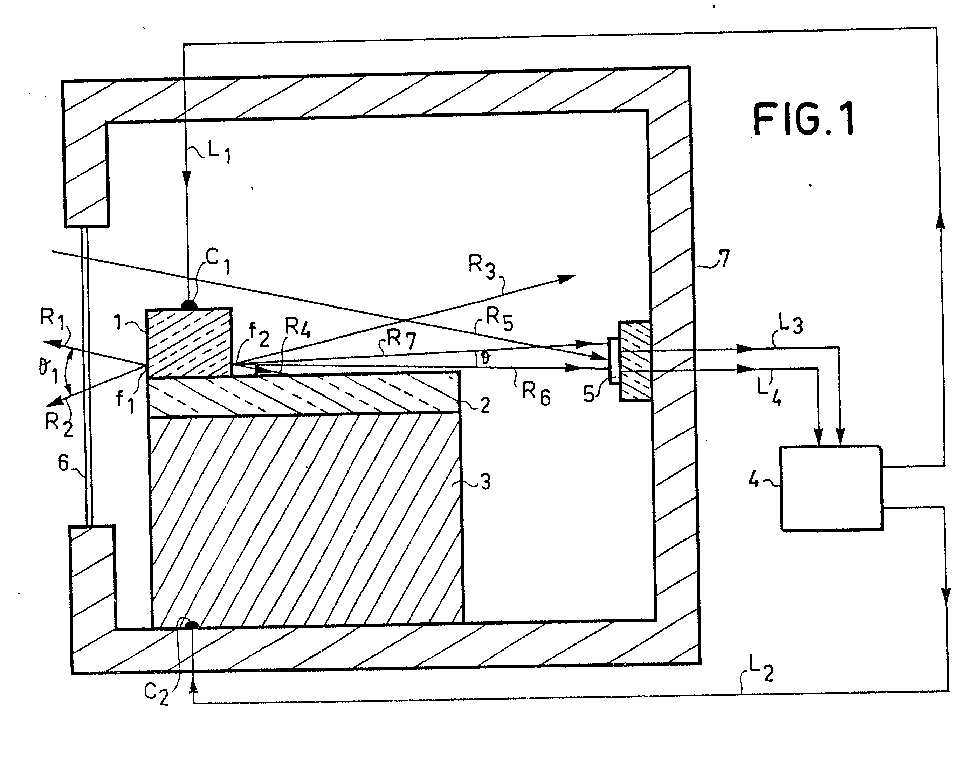

La figure 1 montre le dispositif connu de stabilisation d'un laser semi- conducteur. Le cristal à base de Ga Al As ou de Ga In As P, 1, fournit une puissance optique sortant de la jonction par la face avant d'ouverture angulaire utilisée $\theta_1$.

Le cristal 1 est généralement soudé sur un socle pour la dissipation thermique, qui comporte un bloc métallique en cuivre 3. La face avant du cristal doit être placé à quelques microns en alignement du socle de dissipation. Cette précision est nécessaire pour pouvoir prélever convenablement la puissance optique d'une part et refroidir la jonction d'autre part. On interpose fréquemment une semelle en Silicium 2 entre le cristal 1 et le bloc en cuivre.

La puissance optique de contrôle est prélevée sur la face arrière $f_2$ qui est reçue sur un photodétecteur 5.

L'ensemble cristal 1, bloc de refroidissement 3 et la photodiode 5 sont montés dans un boitier 7 fermé par une fenêtre 6. Cet ensemble sera appelé tête laser.

La tension est appliquée sur le haut du cristal $C_1$ par une connexion $L_1$ et sur le bas du cristal par une connexion $L_2$ soudée dans le bloc de cuivre 3.

On a représenté sur la figure 1 l'alimentation électrique avec son signal d'asservissement par le courant du photodétecteur appliqué par les connections $L_3$ et $L_4$.

Le photodétecteur n'intercepte qu'un faisceau d'angle faible $\theta$ et la stabilisation n'est donc pas obtenue pour une ouverture égale à l'ouverture utile $\theta_1$, angle grand devant $\theta$ .

Sur la figure 1 on a représenté l'ouverture $\theta_1$ sortant par la face arrière limité dans le plan de la figure par le rayon $R_3$ et le rayon $R_4$, qui se réfléchit d'ailleurs sur le silicium. Par ailleurs des rayons de lumière parasite tel que $R_5$ passant par la fenêtre 6 peuvent être reçus de ce photodétecteur 5.

Suivant l'invention la puissance optique de contrôle est propagée vers le photodétecteur 5 par un guide optique.

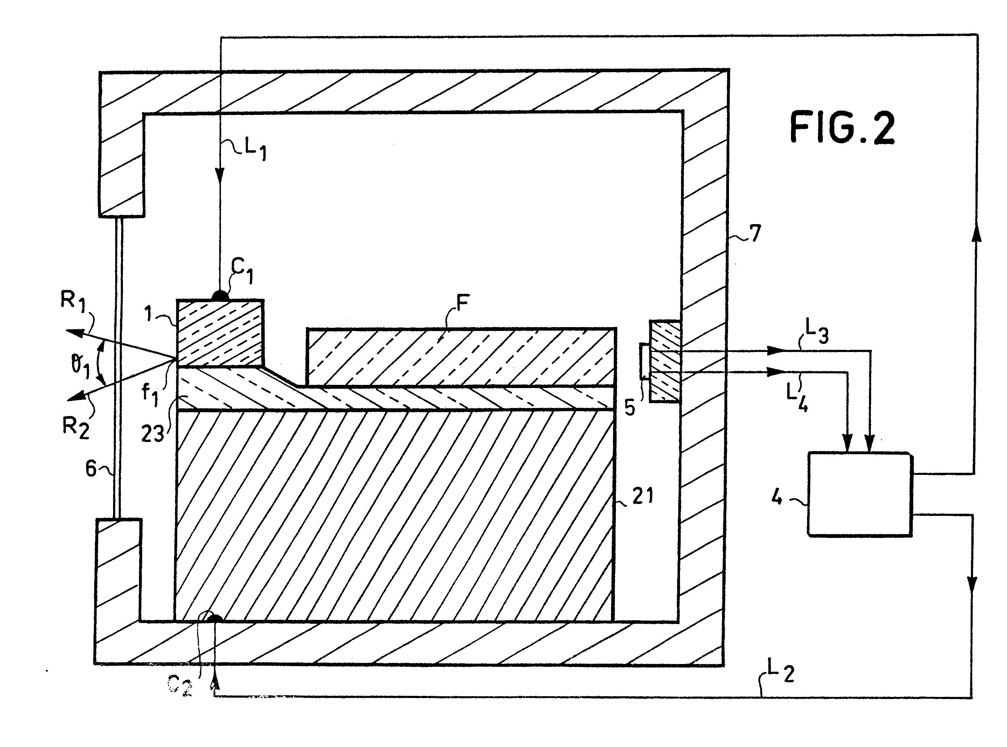

- La figure 2 montre une amélioration pour la réception, qui consiste à placer une fibre optique F, sur le support 22 pour guider la lumière, jusqu'au photodétecteur S.

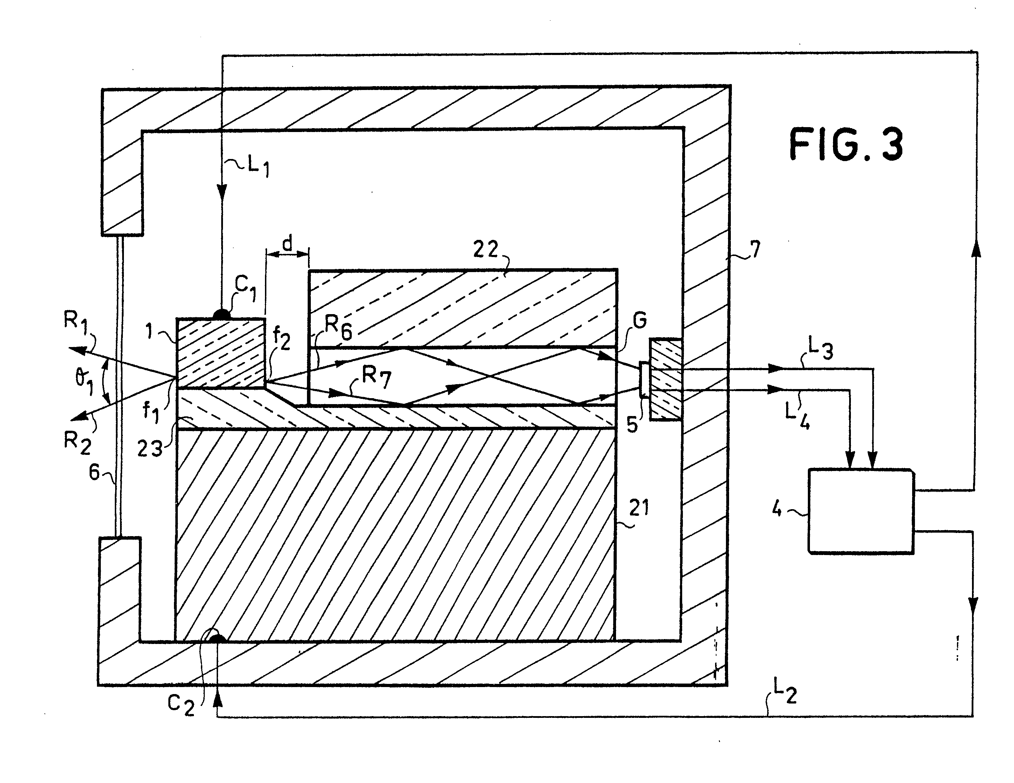

La figure 3 montre un dispositif de guidage, suivant l'invention où le guide G se trouve entre la pièce en silicium et une autre pièce, préférentiellement également et silicium.

La distance d entre la face arrière $f_2$ du cristal 1 est telle que l'ouverture du guide est la même que l'ouverture d'utilisation $\theta_1$. On a représenté deux rayons extrèmes $R_6$ et $R_7$ aboutissant par guidage sur le photodiode 5.

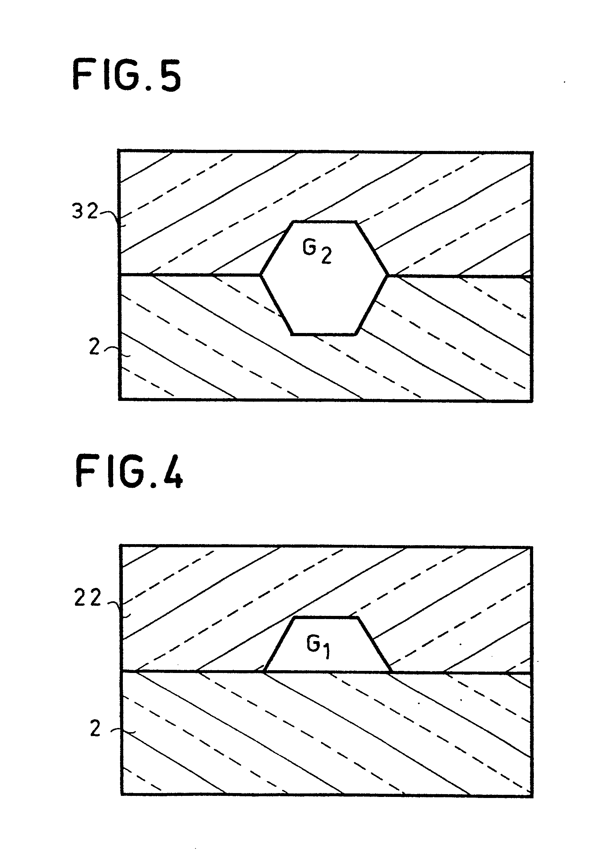

La figure 4 montre une vue en coupe d'un guide $G_1$ pour lequel la pièce 22 a été attaquée par un acide. L'attaque préférentielle suivant les plans, cristallins donne une rainure de section de forme trapézoïdale , mais d'autres formes, comme des sections triangulaires, sont acceptables.

Suivant une variante de l'invention, on forme un guide $G_2$ en attaquant les pièces 2 et 22, les deux rainures étant associées pour former le guide (figure 5).

Finalement on a décrit un dispositif de contrôle de la puissance utile d'un laser semi-conducteur, pour lequel la puissance de contrôle peut être faible, parce qu'on la prélève en totalité. Ceci permet d'obtenir une puissance utile sortant par la face avant, mieux contrôlée, par rapport au dispositif de l'art antérieur. La puissance nécessaire au contrôle issue de la face arrière $f_2$ peut être encore diminué en disposant sur cette face une couche réfléchissante, ce qui augmente par réflexion la puissance utile de la face avant parce qu'on la prélève en totalité.

4

REVENDICATIONS

1. Dispositif de stabilisation de la puissance optique de sortie d'un laser semi-conducteur émettant par sa face avant $(f_1)$ une puissance utile et par sa face arrière $(f_2)$ une puissance de contrôle reçue par un photodétecteur, dont le signal électrique est appliqué à un circuit d'asservissement de l'alimentation de la diode laser caractérisé par le fait que la puissance de contrôle sortant par la face arrière $(f_2)$ du cristal laser (1) entre dans un guide optique (6) et que la puissance sortant de ce guide est reçue par le photodétecteur (5).

2. Dispositif de stabilisation suivant la revendication 1, caractérisé par le fait qu'une pièce (22) ayant une rainure est appliqué sur le support portant la diode laser et que la lumière est guidée dans la rainure.

3. Dispositif de stabilisation suivant la revendication 2 caractérisé par le fait que la lame de support de la diode laser a également une rainure et que les deux rainures forment le guide optique.

4. Dispositif de stabilisation suivant les revendications 2 ou 3 caractérisé par la fait que les pièces ayant des rainures sont réalisées dans un matériau cristallin et que ces rainures comportent des angles vifs.

5. Dispositif de stabilisation suivant la revendication 4 caractérisé par le fait que les pièces ayant des rainures sont en silicium.

6. Dispositif de stabilisation suivant la revendication 1 caractérisé par fait que la lumière est guidée vers le photodétecteur par une fibre optique.

FIG.1

$L_1$

$C_1$

$R_3$

7

$R_1$

$R_5$

$L_3$

1

$f_2$ $R_4$

$R_7$

$\theta_1$

$\theta$

$L_4$

$f_1$

2

$R_6$

5

$R_2$

$3$

$4$

6

$C_2$

$L_2$

1/4

0084003

FIG.2

FIG.3

FIG.5

32

$G_2$

2

FIG.4

22

$G_1$

2